# EUROPEAN PATENT APPLICATION

(11) **EP 4 800 770 A1**
(43) Date of publication of application: **02.09.2026**
(21) Application number: 24896300.1
(22) Date of filing: 15.11.2024
(51) Int. Cl.: H01M 4/525, H01M 4/505, H01M 4/485, H01M 4/131, H01M 10/0525, C01G 53/00, C30B 29/22, C30B 1/02, C30B 1/10

(54) **REGULAR LITHIUM-RICH SINGLE CRYSTAL POSITIVE ELECTRODE MATERIAL AND PREPARATION METHOD THEREFOR, POSITIVE ELECTRODE, AND BATTERY**

(30) Priority: 30.11.2023 CN 202311641397
(71) Applicant: XTC New Energy Materials (Xiamen) Ltd., Xiamen, Fujian 361026 (CN)
(72) Inventor: WEI, Guozhen, Xiamen, Fujian 361026 (CN); WANG, Suheng, Xiamen, Fujian 361026 (CN); XIE, Nengjian, Xiamen, Fujian 361026 (CN); WANG, Jiaqi, Xiamen, Fujian 361026 (CN); WANG, Li, Xiamen, Fujian 361026 (CN)
(74) Representative: Vanzini, Christian
(86) International application number: PCT/CN2024/132438
(87) International publication number: WO 2025/113209

(57) **Abstract**

A regular lithium-rich single crystal positive electrode material and a preparation method therefor, a positive electrode, and a battery. According to the regular lithium-rich single crystal positive electrode material, the regularity α of the positive electrode material is greater than 0.65, and a method for measuring α comprises: calculating the projection area S of each single crystal particle in a microscopic image of a positive electrode material, and measuring and calculating the circumscribed circle area S' of the corresponding single crystal particle, wherein the total calculated number of particles is n, and α = Σ (S/S')/n. The preparation method for the regular lithium-rich single crystal positive electrode material comprises: mixing and sintering a metal hydroxide precursor and a compound containing a doped metal to obtain an intermediate product, and mixing and sintering the intermediate product and a lithium source. The BET of the metal hydroxide precursor is greater than 12 m²/g. The positive electrode material has relatively high regularity, by means of the preparation method, the positive electrode material having relatively high regularity can be prepared, and the positive electrode material having high regularity has good electrochemical performance.

## Description

### CROSS-REFERENCE TO THE RELATED APPLICATION

The present invention claims priority to Chinese Patent Application No. 2023116413978 filed with the China National Intellectual Property Administration on November 30, 2023, and entitled "REGULAR LITHIUM-RICH SINGLE CRYSTAL POSITIVE ELECTRODE MATERIAL AND PREPARATION METHOD THEREFOR, POSITIVE ELECTRODE, AND BATTERY", the contents of which are incorporated herein by reference in entirety.

### TECHNICAL FIELD

The present invention relates to the technical field of battery materials, and specifically relates to a regular lithium-rich single crystal positive electrode material and a preparation method therefor, a positive electrode, and a battery.

### BACKGROUND ART

The development of new energy resources and their industrial chains is a core measure taken by China to achieve carbon peaking and carbon neutrality. Among these efforts, electric vehicles and energy storage solutions centered on lithium-ion batteries constitute a critical part thereof. Lithium-ion batteries can exhibit obvious advantages over other batteries in mass-energy ratio, volume-energy ratio, instantaneous power density, and environmental pollution degree. Among them, lithium-rich positive electrode material is always one of the core components of lithium-ion batteries owing to its cost proportion in lithium-ion batteries and effects on the overall battery performance. With the development of the market and the maturity of technologies, consumers have raised higher requirements for product performance, particularly in terms of product safety and durability. Accordingly, how to address the stability issues of lithium-rich positive electrode materials and to improve the capacity level of products after multiple charge-discharge cycles has become a focus of market research.

Single-crystal lithium-rich positive electrode materials are gradually becoming mainstream in the current lithium battery positive electrode material market due to their superior voltage tolerance, relatively simple material preparation process, and excellent material processability. At present, the main approaches for improving the long-cycle performance of such materials remain focused on two aspects: element doping and surface coating for the material substrate. Such improvement approaches improve the cycle performance of products to a certain extent from the perspectives of material bulk phase and interface structure, but overlook the impact of material morphology on electrochemical performance. According to the basic thermodynamic characteristics of materials, irregular portions (convex polygonal portions) on the material surface can serve as sites for lattice oxygen loss. In particular, acute-angled sites have a higher local specific surface area and higher surface energy, and stronger local thermal effect, such that these sites can be more easily attacked by hydrofluoric acid generated in battery side reactions. Moreover, the reaction is gradually accelerated due to the exothermic effect of the reaction. In addition, lattice oxygen at irregular edges generally has a lower coordination number. At a high delithiation state, oxygen within the material can be released from the material and enter the battery system due to charge imbalance and valence state changes of metal elements. This not only results in irreversible damage to the material but also accelerates the decomposition of the electrolyte, resulting in abnormalities such as bulging of the battery pack and affecting the overall service life of the battery.

### SUMMARY

The present invention aims to provide a regular lithium-rich single-crystal positive electrode material, a preparation method therefor, a positive electrode, and a battery.

The present invention is implemented as follows.

In a first aspect, a regular lithium-rich single-crystal positive electrode material is provided in the present invention, wherein a regularity α of the positive electrode material is greater than 0.65, and a method for measuring α is:
determining a projected area S of each single-crystal particle in a microscopic image of a positive electrode material, and calculating a circumscribed circle area S' of the corresponding single-crystal particle, wherein the total number of statistically counted particles is n, and α = Σ (S/S')/n.

In an optional embodiment, the molecular formula of the regular lithium-rich single-crystal positive electrode material is LiₓNi_{y}Co_{z}MₖOᵣ, where 0.95 ≤ x ≤ 1.10, 0 ≤ y ≤ 1, 0 ≤ z ≤ 1, 0 ≤ k ≤ 1, y + z + k = 1, and 1.8 ≤ r ≤ 2.

M is at least one selected from Mn and Al. The positive electrode material further contains doped metals, wherein the doped metals include a metal element A and a metal element B, the metal element A is at least one selected from the group consisting of Ca, Sr, Ba, Na, Mg, and K, and the metal element B is at least one selected from the group consisting of Zr, Nb, Al, W, Ce, B, P, Sb, Mo, and Ti.

Optionally, 0.55 ≤ y ≤ 0.98, 0 < z ≤ 0.3, and 0 < k ≤ 0.3.

Optionally, a doping amount of metal element A relative to the positive electrode material ranges from 300 ppm to 2,000 ppm, and a doping amount of metal element B relative to the positive electrode material ranges from 2,000 ppm to 10,000 ppm.

In an optional embodiment, an average value of the circumscribed circle radii of the particles of the regular lithium-rich single-crystal positive electrode material ranges from 0.1 µm to 2.5 µm.

Optionally, an average value of the circumscribed circle radii of the particles of the regular lithium-rich single-crystal positive electrode material ranges from 0.8 µm to 1.8 µm.

In an optional embodiment, Dᵥ₁₀ of the particles of the regular lithium-rich single-crystal positive electrode material ranges from 0.5 µm to 3.0 µm, Dᵥ₅₀ ranges from 1.8 µm to 6.0 µm, and Dᵥ₉₀ ranges from 5.0 µm to 12.0 µm.

Optionally, Dᵥ₁₀ of the particles of the regular lithium-rich single-crystal positive electrode material ranges from 0.8 µm to 1.8 µm, Dᵥ₅₀ ranges from 2.5 µm to 4.5 µm, and Dᵥ₉₀ ranges from 6.5 µm to 9.5 µm.

In an optional embodiment, the particle surfaces of the regular lithium-rich single-crystal positive electrode material have a metal oxide coating layer, wherein the metal oxide coating layer is formed from an oxide of at least one metal selected from the group consisting of Ti, Sr, Ba, Na, Mg, K, Co, Mn, Nb, Al, W, Ce, B, P, Sb, and Mo.

In the second aspect, a preparation method for the regular lithium-rich single-crystal positive electrode material according to any one of the preceding embodiments is provided in the present invention, including:
mixing and sintering a metal hydroxide precursor with a compound containing metal element A and a compound containing metal element B to obtain an intermediate product, and mixing and sintering the intermediate product with a lithium source; or
mixing and sintering a metal hydroxide precursor with a compound containing metal element A to obtain an intermediate product, and mixing and sintering the intermediate product with a compound containing metal element B and a lithium source.

The metal hydroxide precursor has a BET larger than 12 m²/g, a Dᵥ₁₀ of 0.3 µm to 2.2 µm, a Dᵥ₅₀ of 1.5 µm to 6.0 µm, and a Dᵥ₉₀ of 4.0 µm to 25.0 µm.

The metal element A is at least one selected from the group consisting of Ca, Sr, Ba, Na, Mg, and K, and the metal element B is at least one selected from the group consisting of Zr, Nb, Al, W, Ce, B, P, Sb, Mo, and Ti.

In an optional embodiment, the method further includes at least one of the following features (1) to (4).
(1) The metal hydroxide precursor has a Dᵥ₁₀ of 0.5 µm to 2.0 µm, a Dᵥ₅₀ of 2.0 µm to 5.0 µm, and a Dᵥ₉₀ of 4.5 µm to 12.0 µm.
(2) The metal hydroxide precursor is mixed and sintered with a lithium source to obtain a primary product; and
   the primary product is pulverized into a material with a particle size Dᵥ₁₀ of 0.5 µm to 3.0 µm, a Dᵥ₅₀ of 1.8 µm to 6.0 µm, and a Dᵥ₉₀ of 5.0 µm to 12.0 µm, followed by at least one additional sintering.

Optionally, before the additional sintering, the pulverized primary product is mixed with a compound containing a coating metal, and sintering is performed again after uniform mixing, wherein the coating metal is at least one selected from the group consisting of Ti, Sr, Ba, Na, Mg, K, Co, Mn, Nb, Al, W, Ce, B, P, Sb and Mo.

Optionally, the coating amount of the metal element in the metal oxide coating layer relative to the positive electrode material ranges from 2,000 ppm to 10,000 ppm.

Optionally, each sintering condition for at least one additional sintering is: oxygen concentration in a synthesis atmosphere furnace of 25% to 90%, heating rate of 1 °C/min to 10 °C/min, a maximum sintering temperature of 500 °C to 900 °C, and a total sintering duration of 12 hours to 30 hours.

(3) Sintering conditions for mixing and sintering the metal hydroxide precursor with the lithium source are: oxygen concentration in a synthesis atmosphere furnace of 25% to 99%, heating rate of 1 °C/min to 10 °C/min, a maximum sintering temperature of 700 °C to 1,200°C, and a total sintering duration of 16 hours to 35 hours.

(4) The compound containing metal element A and the compound containing metal element B are collectively referred to as a compound containing a doped metal, and the compound containing a doped metal has a Dᵥ₅₀ smaller than 2.0 µm.

In an optional embodiment, when mixing and sintering the metal hydroxide precursor with the compound containing a doped metal to obtain the intermediate product, the sintering conditions are: oxygen concentration in a synthesis atmosphere furnace of 25% to 90%, heating rate of 1 °C/min to 10 °C/min, a maximum sintering temperature of 500 °C to 1,000°C, and a total sintering duration of 10 hours to 25 hours.

In a third aspect, a positive electrode is provided in the present invention, wherein the positive electrode is prepared from the positive electrode material provided in the preceding embodiments or from the positive electrode material prepared by the preparation method according to any one of the preceding embodiments.

In the fourth aspect, a battery is provided in the present invention, wherein the battery includes the positive electrode according to the preceding embodiments.

The present invention has the following beneficial effects.

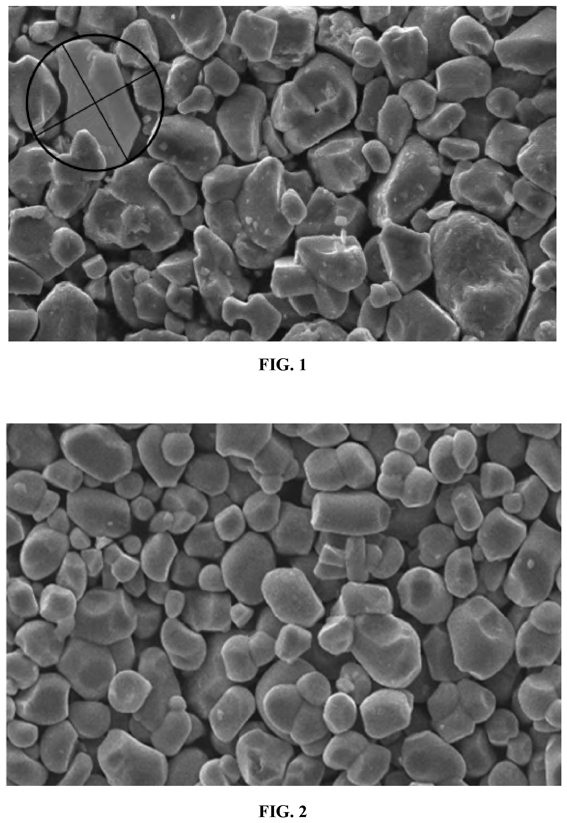

The regular lithium-rich single-crystal positive electrode material provided in the examples of the present invention has a relatively high regularity: α > 0.65, and the ratio of overall convex polygon edge is relatively low. The measurement of α is assisted by SEM (Scanning Electron Microscopy). Image processing software is used to calculate each projected area S and circumscribed circle area S' of single-crystal positive electrode active material (referring to FIG. 1), so as to evaluate the morphological state of the material. From the defined regularity formula α = Σ (S/S')/n, it can be determined that the higher the regularity of the material, the smoother the overall edges of the material and the fewer the edge corners. Therefore, the positive electrode material provided by the present invention is less susceptible to attack by hydrofluoric acid generated in battery side reactions due to its high regularity and exhibits good stability during electrochemical reactions. In addition, the material with high regularity can effectively reduce high-activity sites on the surface, suppress local side reactions, and improve long-term performance, such as battery cycling.

In the preparation method of the positive electrode material provided by the present invention, during preparation, the precursor is mixed and sintered with a compound containing doped metal before the precursor is mixed and sintered with a lithium source, and a precursor with a BET greater than 12 m²/g, a Dᵥ₁₀ of 0.3 µm to 2.2 µm, a Dᵥ₅₀ of 1.5 µm to 6.0 µm, and a Dᵥ₉₀ of 4.0 µm to 25.0 µm is used for preparation, so that a positive electrode material with a regularity α > 0.65 can be obtained.

### BRIEF DESCRIPTION OF THE DRAWINGS

To more clearly illustrate the technical solutions of the examples of the present invention, the accompanying drawings required for the examples of the present invention are briefly introduced below. It should be understood that the following accompanying drawings only show some examples of the present invention and should therefore not be regarded as limiting the scope. For those ordinarily skilled in the art, other relevant accompanying drawings can also be obtained based on these accompanying drawings without making inventive efforts.
FIG. 1 is a schematic diagram of regularity calculation for a single particle.
FIG. 2 is an SEM image of the positive electrode material prepared in Example 1.
FIG. 3 is an SEM image of the positive electrode material prepared in Comparative Example 1.
FIG. 4 is an SEM image of the positive electrode material prepared in Comparative Example 2.
FIG. 5 is a cycle performance comparison curve chart of Example 1 and each comparative example.

### DETAILED DESCRIPTION OF EMBODIMENTS

To make the objectives, technical solutions and advantages of the examples of the present invention clearer, the technical solutions in the examples of the present invention are clearly and completely described below. For the examples where specific conditions are not specified, they shall be conducted in accordance with conventional conditions or conditions recommended by the manufacturer. For the reagents or instruments used where the manufacturer is not specified, they are all conventional products commercially available.

A regular lithium-rich single-crystal positive electrode material is provided in the example of the present invention, wherein the regularity α of the positive electrode material is greater than 0.65, and a method for measuring α is as follows.

The projected area S of each single-crystal particle in a microscopic image of the positive electrode material is determined, and the circumscribed circle area S' of the corresponding single-crystal particle is calculated, where the total number of statistically counted particles is n, and α = Σ (S/S')/n.

The regular lithium-rich single-crystal positive electrode material provided in the examples of the present invention has a relatively high regularity: α > 0.65, and the ratio of overall convex polygon edge is relatively low. The measurement of α is assisted by SEM (Scanning Electron Microscopy). Image processing software is used to calculate each projected area S and circumscribed circle area S' of single-crystal positive electrode active material (referring to FIG. 1), and the total number of statistically counted particles is n. In this way, the morphological state of the material is determined. From the defined regularity formula α = Σ (S/S')/n, it can be determined that the higher the regularity of the material, the smoother the overall edges of the material and the fewer the edge corners. Therefore, the positive electrode material provided by the present invention is less susceptible to attack by hydrofluoric acid generated in battery side reactions due to its high regularity, and exhibits good stability during electrochemical reactions. In addition, the material with high regularity can effectively reduce high-activity sites on the surface, suppress local side reactions, and improve long-term performance such as battery cycling.

In an optional embodiment, the molecular formula of the regular lithium-rich single-crystal positive electrode material is LiₓNi_{y}Co_{z}MₖOᵣ, where 0.95 ≤ x ≤ 1.10, 0 ≤ y ≤ 1, 0 ≤ z ≤ 1, 0 ≤ k ≤ 1, y + z + k = 1, and 1.8 ≤ r ≤ 2.

M is at least one selected from Mn and Al. The positive electrode material further contains doped metals, wherein the doped metals include a metal element A and a metal element B, the metal element A is at least one selected from the group consisting of Ca, Sr, Ba, Na, Mg, and K, and the metal element B is at least one selected from the group consisting of Zr, Nb, Al, W, Ce, B, P, Sb, Mo, and Ti.

Optionally, 0.55 ≤ y ≤ 0.98, 0 < z ≤ 0.3, and 0 < k ≤ 0.3.

Optionally, a doping amount of metal element A relative to the positive electrode material ranges from 300 ppm to 2,000 ppm (such as 300 ppm, 500 ppm, 700 ppm, 1,000 ppm, 1,500 ppm or 2,000 ppm), and a doping amount of metal element B relative to the positive electrode material ranges from 2,000 ppm to 10,000 ppm (such as 2,000 ppm, 3,000 ppm, 5,000 ppm, 8,000 ppm, 9,000 ppm or 10,000 ppm).

Optionally, an average value of circumscribed circle radii of particles of the regular lithium-rich single-crystal positive electrode material ranges from 0.1 µm to 2.5 µm (such as 0.1 µm, 0.5 µm, 1 µm, 2 µm or 2.5 µm), and optionally, 0.8 µm to 1.8 µm (such as 0.8 µm, 1 µm, 1.2 µm, 1.5 µm or 1.8 µm).

Optionally, the particles of the regular lithium-rich single-crystal positive electrode material have a Dᵥ₁₀ of 0.5 µm to 2.2 µm (such as 0.5 µm, 0.8 µm, 1 µm, 1.5 µm, 2 µm or 2.2 µm), a Dᵥ₅₀ of 1.8 µm to 6.0 µm (such as 1.8 µm, 2.5 µm, 3 µm, 3.5 µm, 4 µm, 5 µm or 6 µm), and a Dᵥ₉₀ of 5.0 µm to 12.0 µm (such as 5.0 µm, 8 µm, 10 µm or 12 µm).

Optionally, the particles of the regular lithium-rich single-crystal positive electrode material have a Dᵥ₁₀ of 0.8 µm to 1.8 µm (such as 0.8 µm, 1 µm, 1.2 µm, 1.5 µm or 1.8 µm), a Dᵥ₅₀ of 2.5 µm to 4.5 µm (such as 2.5 µm, 3 µm, 3.5 µm, 4 µm or 4.5 µm), and a Dᵥ₉₀ of 6.5 µm to 9.5 µm (such as 6.5 µm, 7 µm, 7.5 µm, 8 µm, 8.5 µm, 9 µm or 9.5 µm).

Optionally, the particle surfaces of the regular lithium-rich single-crystal positive electrode material have a metal oxide coating layer, wherein the metal oxide coating layer is formed from an oxide of at least one metal selected from the group consisting of Ti, Sr, Ba, Na, Mg, K, Co, Mn, Nb, Al, W, Ce, B, P, Sb, and Mo.

Optionally, the coating amount of the metal element in the metal oxide coating layer relative to the positive electrode material ranges from 2,000 ppm to 10,000 ppm (such as 2,000 ppm, 4,000 ppm, 5,000 ppm, 8,000 ppm or 10,000 ppm).

The preparation method of the above regular lithium-rich single-crystal positive electrode material provided in the example of the present invention includes the following steps.

A metal hydroxide precursor is mixed and sintered with a compound containing metal element A and a compound containing metal element B to obtain an intermediate product, and the intermediate product is mixed and sintered with a lithium source; or
a metal hydroxide precursor is mixed and sintered with a compound containing metal element A to obtain an intermediate product, and the intermediate product is mixed and sintered with a compound containing metal element B and a lithium source.

The metal hydroxide precursor has a BET larger than 12 m²/g, a Dᵥ₁₀ of 0.3 µm to 2.2 µm, a Dᵥ₅₀ of 1.5 µm to 6.0 µm, and a Dᵥ₉₀ of 4.0 µm to 25.0 µm.

The meta element A is at least one selected from the group consisting of Ca, Sr, Ba, Na, Mg, and K, and the metal element B is at least one selected from the group consisting of Zr, Nb, Al, W, Ce, B, P, Sb, Mo, and Ti.

To effectively synthesize a ternary positive electrode material with high regularity, in view of the inheritance from the precursor to the final product, the particle size of the selected metal hydroxide precursor needs to be limited to a certain extent. The particle size of the selected precursor shall be matched with that of the finished product as much as possible, so as to prevent unstable grain boundaries formed during crystal fusion from being broken down again during crushing and forming irregular edges. Therefore, based on the characteristics of the material during sintering, the selected metal hydroxide precursor has a Dᵥ₁₀ of 0.3 µm to 2.2 µm, a Dᵥ₅₀ of 1.5 µm to 6.0 µm, and a Dᵥ₉₀ of 4.0 µm to 25.0 µm. The doped metal A functions to accelerate the fusion reaction of surface oxides during the transformation from hydroxide to oxide by utilizing its fusion-inducing property. The doped metal B mainly functions to support the layered structure and improve ionic conductivity. The doped metals are first mixed and sintered with the metal hydroxide precursor, by utilizing the characteristics of the doped metals, the fusion reaction of surface oxides is accelerated during the transformation from hydroxide to oxide. Meanwhile, due to the reaction potential energy and oxygen spillover effect, the fusion of hydroxide inside the material is accelerated, and grain boundaries formed by the internal and external reaction difference are avoided, thereby preventing the formation of irregular edges after the subsequent powder preparation process. Therefore, to enable the doped metal to infiltrate into the interior of the precursor, a precursor with a BET greater than 12 m²/g needs to be selected. Such a porous precursor also provides a more sufficient growth space for crystals, so that sufficient space is reserved for the material to expand in volume in a certain direction under certain conditions after being mixed with a lithium source, and irregular edges caused by mutual extrusion inside the precursor and reduced regularity of the material are avoided.

Optionally, the metal hydroxide precursor has a Dᵥ₁₀ of 0.5 µm to 2.0 µm (such as 0.5 µm, 0.8 µm, 1 µm, 1.5 µm or 2 µm), a Dᵥ₅₀ of 2.0 µm to 5.0 µm (such as 2 µm, 3 µm, 4 µm or 5 µm), and a Dᵥ₉₀ of 4.5 µm to 12.0 µm (such as 4.5 µm, 6 µm, 8 µm, 10 µm or 12 µm).

Optionally, to achieve better fusion between the precursor and the doped metal, the compound containing doped metal has a Dᵥ₅₀ smaller than 2.0 µm.

For example, specific preparation method are as follows.

### S1. First sintering

A metal hydroxide precursor and a compound containing metal element A are uniformly mixed and sintered to obtain an intermediate product. The doped metal herein is a compound of alkali metals and alkaline earth metals, including but not limited to NaOH, Na₂CO₃, Na₂SO₄, NaS₂O₃, Na₂MoO₄, SrOH, Sr₂CO₃, SrMoO₄, BaSO₄, BaCO₃, MgCO₃, MgSO₄, Mg(OH)₂, K₂CO₃, K₂SO₄, Ca(OH)₂ or CaCO₃.

Optionally, sintering conditions are: oxygen concentration in a synthesis atmosphere furnace of 25% to 90% (such as 25%, 30%, 40%, 50%, 60%, 70%, 80% or 90%), heating rate of 1 °C/min to 10 °C/min (such as 1 °C/min, 3 °C/min, 5 °C/min, 8 °C/min or 10 °C/min), a maximum sintering temperature of 500 °C to 900 °C (such as 500 °C, 600 °C, 700 °C, 800 °C or 900 °C), and a total sintering duration of 10 h to 25 h (such as 10 h, 12 h, 15 h, 18 h, 20 h, 23 h or 25 h).

### S2. Second sintering

The intermediate product obtained in S1 and a lithium source are mixed and sintered; or the intermediate product obtained in S1, a lithium source and a compound containing metal element B are mixed and sintered.

Optionally, sintering conditions of the present step are: oxygen concentration in a synthesis atmosphere furnace of 25% to 99% (such as 25%, 30%, 40%, 50%, 60%, 70%, 80% or 99%), heating rate of 1 °C/min to 10 °C/min (such as 1 °C/min, 3 °C/min, 5 °C/min, 8 °C/min or 10 °C/min), a maximum sintering temperature of 800 °C to 1,000 °C (such as 800 °C, 850 °C, 900 °C, 950 °C or 1,000 °C), and a total sintering duration of 16 h to 35 h (such as 16 h, 20 h, 25 h, 30 h or 35 h).

### S3. Crushing

A primary material is obtained after sintering in step S2, and the primary material is subjected to jet crushing.

It should be noted that mainstream jet crushing processes at present do not change the particle regularity. Therefore, in the present invention, the particle regularity of the finally obtained finished product has almost no obvious correlation with the crushing process. Specific examples of mainstream crushing processes at present are that a jet crushing device is adopted, with a crushing pressure of 0.1 MPa to 0.8 MPa (such as 0.1 MPa, 0.2 MPa, 0.5 MPa or 0.8 MPa). Parameters such as device feeding frequency, nozzles and induced air frequency are set according to device scale and air duct structure of the device.

### S4. Re-sintering

The crushed primary material and a compound containing a coating metal are uniformly mixed and then sintered.

Optionally, sintering conditions of the present step are: oxygen concentration in a synthesis atmosphere furnace of 25% to 90% (such as 25%, 30%, 40%, 50%, 60%, 70%, 80% or 90%), heating rate of 1 °C/min to 10 °C/min (such as 1 °C/min, 3 °C/min, 5 °C/min, 8 °C/min or 10 °C/min), a maximum sintering temperature of 300 °C to 800 °C (such as 300 °C, 400 °C, 500 °C, 600 °C, 700 °C or 800 °C), and a total sintering duration of 12 h to 30 h (such as 12 h, 15 h, 20 h, 25 h or 30 h). A positive electrode material coated with a metal oxide coating can be prepared. The sintering temperatures in steps S1, S2 and S4 are different, and the temperature settings in each step generally satisfy S4 < S1 < S2. This is because the material needs to fully combine with a large amount of lithium source during S2, so the highest growth temperature is required. During S1, alkali metals and alkaline earth metals need to fully fuse inside and outside the material, so a relatively high temperature is also required. As a coating process, the re-sintering in S4 requires the additive to react with the primary material fully and remain on the surface of the primary material, so the temperature is relatively low, but the temperature range is wide.

Optionally, the doped metal and the coating metal are at least one each independently selected from the group consisting of Ti, Sr, Ba, Na, Mg, K, Co, Mn, Nb, Al, W, Ce, B, P, Sb and Mo. The compound containing doped metal and the compound containing coating metal mentioned in the present invention can be oxides, hydroxides, carbonates, sulfates, molybdates and the like of the above metal elements, specifically such as NaOH, Na₂CO₃, Na₂SO₄, NaS₂O₃, Na₂MoO₄, SrOH, Sr₂CO₃, SrMoO₄, BaSO₄, BaCO₃, MgCO₃, MgSO₄, Mg(OH)₂, K₂CO₃, K₂SO₄, Ca(OH)₂ or CaCO₃.

A positive electrode provided in an example of the present invention is prepared from the positive electrode material provided in an example of the present invention or from the positive electrode material prepared by the preparation method provided in an example of the present invention.

A battery provided in an example of the present invention includes the positive electrode provided in an example of the present invention.

The features and performance of the present invention are further described in detail below with reference to examples.

### Example 1

(1) Ni_{0.6}Co_{0.1}Mn_{0.3}(OH)₂ and SrO were mixed by a high-speed mixer, wherein the content of SrO was 500 ppm to 2,000 ppm. The Ni_{0.6}Co_{0.1}Mn_{0.3}(OH)₂ had a Dᵥ₁₀ of 2.8 µm, a Dᵥ₅₀ of 3.5 µm, a Dᵥ₉₀ of 5.0 µm, and a BET of 20 m²/g. The SrO had a Dᵥ₅₀ of 1.8 µm. The mixed material was loaded into a sagger and sintered in an atmosphere furnace. The sintering atmosphere was a mixed atmosphere of oxygen and air, wherein the volume ratio of oxygen was 40%. The sintering furnace was heated from room temperature to 760 °C, the heating duration was 6 hours, and the holding duration was 10 hours to obtain an intermediate product.
(2) The intermediate product was mixed with LiOH, Li₂CO₃, ZrO₂, TiO₂, Al₂O₃ and WO₃ by the high-flow mixer. The mixed material was loaded into the sagger and sintered in the atmosphere furnace. The sintering atmosphere was a mixed atmosphere of oxygen and air, wherein the volume ratio of oxygen was 80%. The sintering furnace was heated from room temperature to 943 °C, the heating duration was 10 hours, and the holding duration was 12 hours. After being discharged from the furnace, the material was subjected to jet crushing and dispersion. The crushing equipment was Saishan Y0200T, and the crushing operation parameters were a crushing pressure of 0.25 MPa and a feeding frequency of 80 Hz, so as to obtain a primary material. The primary material had a composition of Li_{1.02}Ni_{0.6}Co_{0.1}Mn_{0.3}O₂ and contained Sr, Zr, Ti, Al and W as doped elements, wherein the doping amounts of Sr, Zr, Ti, Al and W were 500 ppm, 2,500 ppm, 700 ppm, 500 ppm and 1,500 ppm, respectively.
(3) The primary material was mixed with Al₂O₃, TiO₂ and WO₃ by the high-speed mixer. The mixed material was then loaded into the sagger and sintered in the atmosphere furnace. The sintering atmosphere was a mixed atmosphere of oxygen and air, wherein the volume ratio of oxygen was 50%. The sintering furnace was heated from room temperature to a temperature in the range of 400 °C to 500 °C, the heating duration was 4 hours, and the holding duration was 8 hours. Finally, a finished regular lithium-rich single-crystal positive electrode material Li_{1.02}Ni_{0.6}Co_{0.1}Mn_{0.3}O₂ with a coating layer was obtained, wherein the material contained Zr, Ti, Al, W and Sr as doped elements, and the doping amounts were 500 ppm, 2,500 ppm, 700 ppm, 500 ppm and 1,500 ppm, respectively.

The material further contained Al, Ti and W as coating elements, and the coating amounts were 700 ppm, 1,200 ppm and 600 ppm, respectively.

### Example 2

The present example was basically the same as Example 1, with the only difference as follows.
(1) Ni_{0.68}Co_{0.07}Mn_{0.25}(OH)₂ and Ba(OH)₂ were mixed by the high-speed mixer, wherein the metal hydroxide used had a BET of 17 m²/g, a Dᵥ₁₀ of 2 µm, a Dᵥ₅₀ of 5 µm, and a Dᵥ₉₀ of 12 µm. The Ba(OH)₂ had a Dᵥ₅₀ of 1.5 µm.
(2) The intermediate product, LiOH, Li₂CO₃, ZrO₂, Al₂O₃ and WO₃ were sintered together to obtain the primary material with doping amounts of Zr, Al, W and Ba being 2,500 ppm, 1,000 ppm, 1,300 ppm and 700 ppm, respectively.
(3) The primary material was mixed and sintered with Al₂O₃ and TiO₂. Finally, a finished regular lithium-rich single-crystal positive electrode material with a coating layer, Li_{1.04}Ni_{0.68}Co_{0.07}Mn_{0.25}O₂, was obtained, wherein the material contained Zr, Al, W and Ba as doped elements with doping amounts of 2,500 ppm, 1,000 ppm, 1,300 ppm and 700 ppm, respectively, and contained Al and Ti as coating elements with coating amounts of 1,000 ppm and 1,200 ppm, respectively.

### Example 3

The present example was basically the same as Example 1, with the only difference being that:
the metal hydroxide used had a BET of 20 m²/g, a Dᵥ₁₀ of 0.5 µm, a Dᵥ₅₀ of 2 µm, and a Dᵥ₉₀ of 4.5 µm.

### Example 4

The present example was basically the same as Example 1, with the only difference being that: the metal hydroxide used had a BET of 18 m²/g, a Dᵥ₁₀ of 2.2 µm, a Dᵥ₅₀ of 6.0 µm, and a Dᵥ₉₀ of 25 µm.

### Example 5

The present example was basically the same as Example 1, with the only difference being that: the metal hydroxide used had a BET of 16 m²/g, a Dᵥ₁₀ of 0.3 µm, a Dᵥ₅₀ of 1.5 µm, and a Dᵥ₉₀ of 4.0 µm.

### Example 6

The present example was basically the same as Example 1, with the only difference being that: the metal hydroxide used had a BET of 16 m²/g, a Dᵥ₁₀ of 0.5 µm, a Dᵥ₅₀ of 2.0 µm, and a Dᵥ₉₀ of 4.5 µm.

### Example 7

The present example was basically the same as Example 1, with the only difference being that step (3) was omitted compared with Example 1.

### Example 8

The present example was basically the same as Example 1, with the only difference being that the used precursor Ni_{0.65}Co_{0.07}Mn_{0.28}(OH)₂ had a BET of 25 m²/g, a Dᵥ₁₀ of 0.8 µm, a Dᵥ₅₀ of 3.7 µm, and a Dᵥ₉₀ of 5.5 µm. The temperature of the first sintering was 500 °C, the temperature of the second sintering was 700 °C, and the temperature of the third sintering was 500 °C.

### Example 9

The present example was basically the same as Example 2, with the only difference being that the used precursor Ni_{0.58}Co_{0.14}Mn_{0.28}(OH)₂ had a BET of 26 m²/g, a Dᵥ₁₀ of 0.6 µm, a Dᵥ₅₀ of 3.0 µm, and a Dᵥ₉₀ of 5.1 µm. The temperature of the first sintering was 860 °C, the temperature of the second sintering was 980 °C, and the temperature of the third sintering was 800 °C.

### Comparative Example 1

The present comparative example was basically the same as Example 1, with the only difference being that step (1) was omitted, that is, no SrO was doped.

### Comparative Example 2

The present comparative example was basically the same as Example 1, with the only difference being that the BET of the used precursor was 8 m²/g, the Dᵥ₁₀ was 3 µm, the Dᵥ₅₀ was 3.5 µm, and the Dᵥ₉₀ was 5.6 µm.

### Experimental Example 1

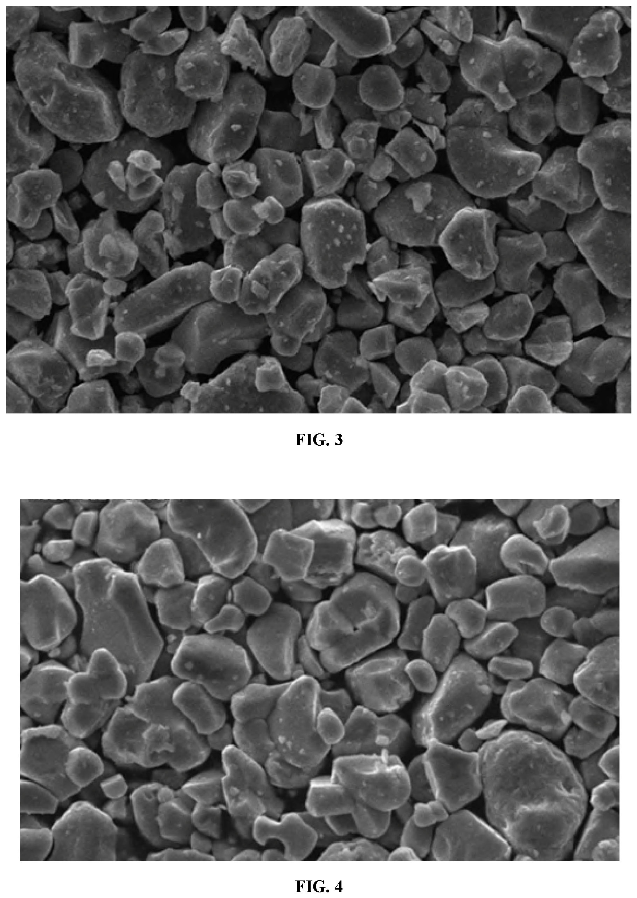

(1) Products prepared from each example and comparative example were tiled on a conductive adhesive and photographed under a flex1000 scanning electron microscope. An electron micrograph was taken at a magnification of 4000 times. The electron micrographs of Example 1 and Comparative Examples 1-2 are shown in FIGS. 2-4.
   Comparison between FIG. 2 and FIGS. 3 and 4 shows that the positive electrode material prepared in Example 1 is significantly more regular than those in the comparative examples. This indicates: 1. sintering the precursor with an oxide containing doped metal first promotes improved regularity of the positive electrode material; and 2. using a precursor with a higher BET to prepare the positive electrode material promotes improved regularity of the positive electrode material.
(2) The electron micrographs were analyzed by MiPar software to obtain the areas of all complete particles, and parts misjudged by the equipment were manually removed. The longest axis length of each particle was also obtained at the same time, and the area of the circumscribed circle was calculated accordingly. For brevity, only the particle data counted for Example 1 and Comparative Example 1 are shown in Table 1 and Table 2, respectively. The calculated regularity data of each example and the comparative example are compiled in Table 3.

**Table 1 Statistical data of the positive electrode material prepared in Example 1.**

| Particle No. | S | S' |
|---|---|---|
| 1 | 2.48 | 2.8 |
| 2 | 3.98 | 7.41 |
| 3 | 4.01 | 5.13 |
| 4 | 4.7 | 5.88 |
| 5 | 2.94 | 4.48 |
| 6 | 1.84 | 2.19 |
| 7 | 9.92 | 18.44 |
| 8 | 0.98 | 1.13 |
| 9 | 2.45 | 3.06 |
| 10 | 6.43 | 14.52 |
| 11 | 5.52 | 5.99 |
| 12 | 2.84 | 4.35 |
| 13 | 0.59 | 1.29 |
| 14 | 1.9 | 2.81 |
| 15 | 2.72 | 4.94 |
| 16 | 12.06 | 14.62 |
| 17 | 3.79 | 5.71 |
| 18 | 1.65 | 3.15 |
| 19 | 8.74 | 11.61 |
| 20 | 3.78 | 4.44 |
| 21 | 6.71 | 17.87 |
| 22 | 7.56 | 11.06 |
| 23 | 6.93 | 8.87 |
| 24 | 3.85 | 6.81 |
| 25 | 1.57 | 2.24 |
| 26 | 2.48 | 4.76 |
| 27 | 1.02 | 1.7 |
| 28 | 5.74 | 6.48 |
| 29 | 2.73 | 6.02 |
| 30 | 4.08 | 5.54 |
| 31 | 3.04 | 3.9 |
| 32 | 0.03 | 0.1 |
| 33 | 3.02 | 3.65 |
| 34 | 7.4 | 12.13 |
| 35 | 1.19 | 1.9 |
| 36 | 20.58 | 33.56 |
| 37 | 1.23 | 2.9 |
| 38 | 3.88 | 4.79 |
| 39 | 0.82 | 1.96 |
| 40 | 3.45 | 4.52 |
| 41 | 2.94 | 3.67 |
| 42 | 14.06 | 45.18 |
| 43 | 6.6 | 15.48 |
| 44 | 7.75 | 11.68 |
| 45 | 1.63 | 1.99 |
| 46 | 2.21 | 2.71 |
| 47 | 7.22 | 7.68 |
| 48 | 1.15 | 1.25 |
| 49 | 3.63 | 5.87 |
| 50 | 8.12 | 11.39 |
| 51 | 1.12 | 1.78 |
| 52 | 13 | 34.19 |
| 53 | 2.41 | 2.73 |
| 54 | 4.97 | 7.82 |
| 55 | 1.75 | 2.05 |
| 56 | 6.18 | 17.41 |
| 57 | 0.77 | 1.7 |
| 58 | 3.96 | 4.51 |
| 59 | 4.87 | 6.44 |
| 60 | 3.2 | 3.83 |
| 61 | 0.36 | 0.79 |
| 62 | 2.07 | 2.39 |
| 63 | 0.6 | 0.71 |
| 64 | 3.42 | 5.11 |
| 65 | 1.22 | 1.77 |
| 66 | 4.67 | 5.21 |
| 67 | 2.49 | 2.57 |
| 68 | 5.08 | 7.83 |
| 69 | 1.11 | 1.46 |
| 70 | 1.12 | 1.23 |
| 71 | 3.86 | 5.44 |
| 72 | 4.09 | 7.41 |
| 73 | 4.98 | 11.75 |
| 74 | 1.93 | 2.78 |
| 75 | 6.55 | 9.91 |
| 76 | 1.22 | 1.43 |
| 77 | 0.1 | 0.5 |
| 78 | 0.77 | 1.47 |
| 79 | 0.95 | 1.14 |
| 80 | 0.83 | 1.03 |
| 81 | 0.1 | 0.39 |
| 82 | 1.71 | 2.14 |
| 83 | 4.08 | 4.67 |
| 84 | 2.47 | 4.38 |
| 85 | 9.01 | 14.58 |
| 86 | 0.45 | 0.8 |
| 87 | 1.42 | 2.04 |
| 88 | 8.81 | 11.28 |
| 89 | 1.03 | 1.34 |
| 90 | 3.73 | 4.45 |
| 91 | 7.56 | 12.03 |
| 92 | 9.45 | 15.1 |
| 93 | 7.66 | 9.16 |
| 94 | 0.79 | 1.04 |
| 95 | 1.21 | 1.49 |
| 96 | 2.65 | 3.93 |
| 97 | 4.25 | 6.28 |
| 98 | 6.11 | 13.17 |
| 99 | 1.44 | 2.92 |
| 100 | 5.89 | 7.58 |
| 101 | 6.03 | 7.89 |
| 102 | 4.98 | 6.54 |
| 103 | 2.01 | 2.77 |
| 104 | 2.9 | 4.09 |
| 105 | 4.1 | 4.82 |
| 106 | 5.3 | 6.38 |

**Table 2 Statistical data of the positive electrode material prepared in Comparative Example 1.**

| Particle Batch No. | S | S' |
|---|---|---|
| 1 | 0.86 | 1.12 |
| 2 | 0.91 | 1.29 |
| 3 | 0.80 | 1.61 |
| 4 | 0.87 | 1.62 |
| 5 | 0.72 | 1.62 |
| 6 | 1.04 | 1.68 |
| 7 | 0.74 | 1.74 |
| 8 | 1.31 | 1.82 |
| 9 | 1.03 | 1.83 |
| 10 | 0.84 | 1.86 |
| 11 | 1.63 | 1.87 |
| 12 | 1.31 | 1.90 |
| 13 | 1.34 | 1.91 |
| 14 | 1.02 | 1.93 |
| 15 | 1.02 | 1.94 |
| 16 | 1.29 | 2.10 |
| 17 | 0.93 | 2.20 |
| 18 | 1.90 | 2.22 |
| 19 | 1.63 | 2.23 |
| 20 | 1.08 | 2.32 |
| 21 | 1.12 | 2.40 |
| 22 | 1.46 | 2.56 |
| 23 | 1.52 | 2.57 |
| 24 | 2.19 | 2.57 |
| 25 | 1.45 | 2.63 |
| 26 | 1.31 | 2.65 |
| 27 | 1.56 | 2.67 |
| 28 | 2.28 | 2.73 |
| 29 | 0.91 | 2.84 |
| 30 | 2.58 | 3.01 |
| 31 | 1.83 | 3.02 |
| 32 | 1.79 | 3.06 |
| 33 | 1.37 | 3.15 |
| 34 | 2.15 | 3.25 |
| 35 | 2.47 | 3.32 |
| 36 | 2.79 | 3.47 |
| 37 | 2.82 | 3.50 |
| 38 | 3.30 | 3.61 |
| 39 | 2.12 | 3.72 |
| 40 | 1.88 | 3.76 |
| 41 | 1.92 | 3.84 |
| 42 | 3.79 | 3.86 |
| 43 | 3.64 | 4.14 |
| 44 | 3.35 | 4.24 |
| 45 | 1.16 | 4.35 |
| 46 | 2.33 | 4.39 |
| 47 | 4.21 | 4.46 |
| 48 | 1.94 | 4.54 |
| 49 | 2.47 | 4.56 |
| 50 | 1.92 | 4.67 |
| 51 | 4.55 | 4.88 |
| 52 | 2.14 | 5.06 |
| 53 | 4.28 | 5.08 |
| 54 | 3.46 | 5.19 |
| 55 | 2.78 | 5.25 |
| 56 | 4.29 | 5.43 |
| 57 | 4.87 | 5.48 |
| 58 | 3.85 | 5.57 |
| 59 | 3.41 | 5.76 |
| 60 | 4.24 | 5.85 |
| 61 | 3.23 | 5.90 |
| 62 | 3.02 | 5.95 |
| 63 | 3.50 | 6.05 |
| 64 | 4.72 | 6.22 |
| 65 | 5.24 | 6.34 |
| 66 | 3.50 | 6.37 |
| 67 | 4.17 | 6.97 |
| 68 | 3.76 | 6.99 |
| 69 | 3.28 | 7.45 |
| 70 | 5.84 | 7.68 |
| 71 | 2.85 | 7.72 |
| 72 | 2.92 | 7.72 |
| 73 | 3.43 | 7.72 |
| 74 | 3.63 | 7.82 |
| 75 | 5.86 | 7.86 |
| 76 | 3.89 | 7.89 |
| 77 | 3.58 | 8.50 |
| 78 | 5.69 | 8.73 |
| 79 | 5.42 | 8.80 |
| 80 | 2.44 | 8.84 |
| 81 | 7.34 | 8.85 |
| 82 | 3.93 | 8.92 |
| 83 | 5.99 | 9.14 |
| 84 | 6.80 | 9.25 |
| 85 | 7.51 | 10.25 |
| 86 | 7.92 | 10.31 |
| 87 | 6.13 | 11.03 |
| 88 | 3.69 | 13.84 |
| 89 | 12.08 | 16.85 |
| 90 | 9.85 | 17.30 |
| 91 | 12.42 | 17.44 |
| 92 | 11.20 | 17.64 |
| 93 | 11.30 | 17.86 |
| 94 | 8.73 | 18.13 |
| 95 | 9.40 | 18.82 |
| 96 | 12.11 | 20.98 |
| 97 | 10.95 | 27.93 |
| 98 | 18.14 | 37.63 |
| 99 | 15.70 | 41.59 |
| 100 | 29.75 | 48.13 |

**Table 3 Regularity of the positive electrode materials prepared in the examples and comparative examples**

| | α |
|---|---|
| Example 1 | 0.68 |
| Example 2 | 0.69 |
| Example 3 | 0.69 |
| Example 4 | 0.66 |
| Example 5 | 0.67 |
| Example 6 | 0.69 |
| Example 7 | 0.70 |
| Example 8 | 0.67 |
| Example 9 | 0.71 |
| Comparative Example 1 | 0.61 |
| Comparative Example 2 | 0.63 |

### Experimental Example 2

Electrochemical performances of the positive electrode materials prepared in the examples and comparative examples were tested. Details are as follows.

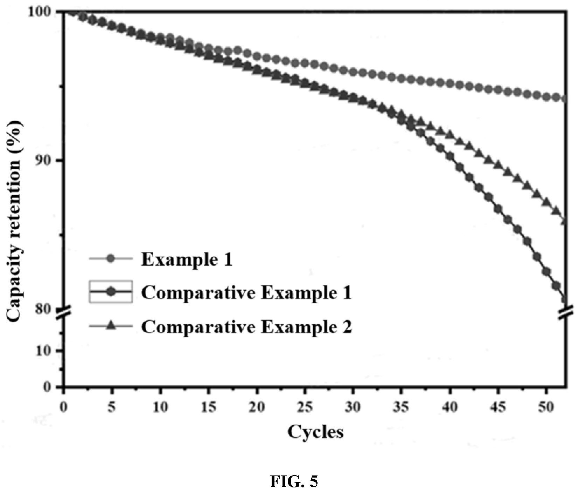

Samples of Example 1 and Comparative Examples 1-3 were prepared into electrode sheets by slurry mixing, coating and roll pressing, and then assembled into coin cells with lithium sheets, separators, electrolytes and necessary auxiliary materials. The coin cells were tested for capacity retention after 50 cycles at a voltage of 4.45 V, a high temperature of 45 °C, and a rate of 1 C. The results are shown in FIG. 5 and Table 4.

**Table 4 Cycle comparison between Example 1 and Comparative Example 1**

| | Cycle retention after 50 cycles |
|---|---|
| Example 1 | 94.3% |
| Comparative Example 1 | 80.6% |
| Comparative Example 2 | 85.7% |

In summary, the regular lithium-rich single-crystal positive electrode material provided in the examples of the present invention has a relatively high regularity: α > 0.65, and the ratio of overall convex polygon edge is relatively low. The positive electrode material provided by the present invention is less susceptible to attack by hydrofluoric acid generated in battery side reactions due to its high regularity, and exhibits good stability during electrochemical reactions. In addition, the material with high regularity can effectively reduce high-activity sites on the surface, suppress local side reactions, and improve long-term performance, such as battery cycling.

In the preparation method of the positive electrode material provided by the present invention, during preparation, the precursor is mixed and sintered with a compound containing doped metal before the precursor is mixed and sintered with a lithium source, and a precursor with a BET greater than 12 m²/g, a Dᵥ₁₀ of 0.3 µm to 3.2 µm, a Dᵥ₅₀ of 1.5 µm to 6.5 µm, and a Dᵥ₉₀ of 4.0 µm to 27.0 µm is used for preparation, so that a positive electrode material with a regularity α > 0.65 can be obtained.

The above are only optional examples of the present invention and are not intended to limit the present invention. For those skilled in the art, the present invention can have various modifications and changes. Any modification, equivalent replacement, improvement, etc. made within the spirit and principle of the present invention shall be included in the protection scope of the present invention.

### INDUSTRIAL APPLICABILITY

The regularity α of the regular lithium-rich single-crystal positive electrode material provided in the present solution is greater than 0.65, and a method for measuring α is that the projected area S of each single-crystal particle in a microscopic image of the positive electrode material is determined, the circumscribed circle area S' of the corresponding single-crystal particle is calculated, the total number of counted particles is n, and α = Σ (S/S')/n. The preparation method of the positive electrode material includes: mixing and sintering a metal hydroxide precursor with a compound containing a doped metal to obtain an intermediate product; and mixing and sintering the intermediate product with a lithium source. The BET of the metal hydroxide precursor is greater than 12 m²/g. The positive electrode material disclosed in the present invention has relatively high regularity; the preparation method can produce a positive electrode material with high regularity, and the positive electrode material with high regularity has excellent electrochemical performance.

## Claims

1. A regular lithium-rich single-crystal positive electrode material, **characterized in that** a regularity α of the positive electrode material is greater than 0.65, and a method for measuring the α is:
determining a projected area S of each single-crystal particle in a microscopic image of the positive electrode material, and calculating a circumscribed circle area S' of the corresponding single-crystal particle, wherein a total number of statistically counted particles is n, and α = Σ (S/S')/n.

2. The regular lithium-rich single-crystal positive electrode material according to claim 1, wherein a molecular formula of the regular lithium-rich single-crystal positive electrode material is LiₓNi_{y}Co_{z}MₖOᵣ, wherein 0.95 ≤ x ≤ 1.10, 0 ≤ y ≤ 1, 0 ≤ z ≤ 1, 0 ≤ k ≤ 1, y + z + k = 1, and 1.8 ≤ r ≤ 2;
M is at least one selected from Mn and Al; the positive electrode material further contains doped metals, wherein the doped metals comprise a metal element A and a metal element B, the metal element A is at least one selected from the group consisting of Ca, Sr, Ba, Na, Mg, and K, and the metal element B is at least one selected from the group consisting of Zr, Nb, Al, W, Ce, B, P, Sb, Mo, and Ti;
optionally, 0.55 ≤ y ≤ 0.98, 0 < z ≤ 0.3, and 0 < k ≤ 0.3; and
optionally, a doping amount of the metal element A relative to the positive electrode material ranges from 300 ppm to 2,000 ppm, and a doping amount of the metal element B relative to the positive electrode material ranges from 2,000 ppm to 10,000 ppm.

3. The regular lithium-rich single-crystal positive electrode material according to claim 1 or 2, wherein an average value of circumscribed circle radii of particles of the regular lithium-rich single-crystal positive electrode material ranges from 0.1 µm to 2.5 µm; and
optionally, the average value of the circumscribed circle radii of the particles of the regular lithium-rich single-crystal positive electrode material ranges from 0.8 µm to 1.8 µm.

4. The regular lithium-rich single-crystal positive electrode material according to any one of claims 1-3, wherein a Dᵥ₁₀ of particles of the regular lithium-rich single-crystal positive electrode material ranges from 0.5 µm to 3.0 µm, a Dᵥ₅₀ ranges from 1.8 µm to 6.0 µm, and a Dᵥ₉₀ ranges from 5.0 µm to 12.0 µm; and
optionally, the Dᵥ₁₀ of the particles of the regular lithium-rich single-crystal positive electrode material ranges from 0.8 µm to 1.8 µm, the Dᵥ₅₀ ranges from 2.5 µm to 4.5 µm, and the Dᵥ₉₀ ranges from 6.5 µm to 9.5 µm.

5. The regular lithium-rich single-crystal positive electrode material according to any one of claims 1-4, wherein particle surfaces of the regular lithium-rich single-crystal positive electrode material have a metal oxide coating layer, and the metal oxide coating layer is formed from an oxide of at least one metal selected from the group consisting of Ti, Sr, Ba, Na, Mg, K, Co, Mn, Nb, Al, W, Ce, B, P, Sb, and Mo; and
optionally, a coating amount of the metal element in the metal oxide coating layer relative to the positive electrode material ranges from 2,000 ppm to 10,000 ppm.

6. A preparation method of the regular lithium-rich single-crystal positive electrode material according to any one of claims 1-5, **characterized by** comprising:
mixing and sintering a metal hydroxide precursor with a compound containing metal element A and a compound containing metal element B to obtain an intermediate product, and mixing and sintering the intermediate product with a lithium source; or
mixing and sintering a metal hydroxide precursor with a compound containing metal element A to obtain an intermediate product, and mixing and sintering the intermediate product with a compound containing metal element B and a lithium source, wherein
the metal hydroxide precursor has a BET larger than 12 m²/g, a Dᵥ₁₀ of 0.3 µm to 2.2 µm, a Dᵥ₅₀ of 1.5 µm to 6.0 µm, and a Dᵥ₉₀ of 4.0 µm to 25.0 µm; and
the metal element A is at least one selected from the group consisting of Ca, Sr, Ba, Na, Mg, and K, and the metal element B is at least one selected from the group consisting of Zr, Nb, Al, W, Ce, B, P, Sb, Mo, and Ti.

7. The preparation method according to claim 6, further comprising at least one of following features (1) to (4):
(1) the metal hydroxide precursor has the Dᵥ₁₀ of 0.5 µm to 2.0 µm, the Dᵥ₅₀ of 2.0 µm to 5.0 µm, and the Dᵥ₉₀ of 4.5 µm to 12.0 µm;
(2) the metal hydroxide precursor is mixed and sintered with a lithium source to obtain a primary product; and
the primary product is pulverized into a material with the Dᵥ₁₀ of 0.5 µm to 3.0 µm, the Dᵥ₅₀ of 1.8 µm to 6.0 µm, and the Dᵥ₉₀ of 5.0 µm to12.0 µm, followed by at least one additional sintering;
optionally, before the additional sintering, the pulverized primary product is mixed with a compound containing a coating metal, and sintering is performed again after uniform mixing, wherein the coating metal is at least one selected from the group consisting of Ti, Sr, Ba, Na, Mg, K, Co, Mn, Nb, Al, W, Ce, B, P, Sb and Mo; and
optionally, each sintering condition for the at least one additional sintering is: an oxygen concentration in a synthesis atmosphere furnace of 25% to 90%, a heating rate of 1 °C/min to 10 °C/min, a maximum sintering temperature of 500 °C to 900 °C, and a total sintering duration of 12 hours to 30 hours;
(3) sintering conditions for mixing and sintering the metal hydroxide precursor with the lithium source are: an oxygen concentration in a synthesis atmosphere furnace of 25% to 99%, a heating rate of 1 °C/min to 10 °C/min, a maximum sintering temperature of 700 °C to 1,200°C, and a total sintering duration of 16 hours to 35 hours;
(4) the compound containing metal element A and the compound containing metal element B are collectively referred to as a compound containing a doped metal, and the compound containing a doped metal has a Dᵥ₅₀ smaller than 2.0 µm.

8. The preparation method according to claim 6 or 7, wherein when mixing and sintering the metal hydroxide precursor with the compound containing a doped metal to obtain the intermediate product, sintering conditions are: an oxygen concentration in a synthesis atmosphere furnace of 25% to 90%, a heating rate of 1 °C/min to 10 °C/min, a maximum sintering temperature of 500 °C to 1,000°C, and a total sintering duration of 10 hours to 25 hours.

9. A positive electrode, **characterized in that** the positive electrode is prepared by the positive electrode material according to any one of claims 1-5, or the positive electrode material prepared by the preparation method according to any one of claims 6-8.

10. A battery, **characterized by** comprising the electrode according to claim 9.
